Europäisches Patentamt

European Patent Office

Office européen des brevets

(11) Publication number: **0 208 433**
A2

(12) # EUROPEAN PATENT APPLICATION

(21) Application number: 86304587.8

(22) Date of filing: 16.06.86

(51) Int. Cl.⁴: **H 03 F 1/08**
H 03 F 3/347, H 03 F 1/48

(30) Priority: 05.07.85 US 752467

(43) Date of publication of application:
14.01.87 Bulletin 87/3

(84) Designated Contracting States:
AT BE CH DE FR GB IT LI LU NL SE

(71) Applicant: Irvine, Robert G.
1393 Carthage Court
Claremont California 91711(US)

(72) Inventor: Irvine, Robert G.
1393 Carthage Court
Claremont California 91711(US)

(74) Representative: Pears, David Ashley et al,
REDDIE & GROSE 16 Theobalds Road
London WC1X 8PL(GB)

(54) Response-gain independent amplifier.

(57) A feedback amplifier providing very wide bandwidth which is substantially independent of amplifier gain over a substantial range of frequencies within a given bandwidth. The amplifier employs a pair of operational amplifier stages (OA₁, OA₂) connected in tandem in a circuit utilizing current feedback. The inverting inputs of the two stages are tied together at a common point (V₁), thereby developing the current feedback to render the gain and bandwidth of the circuit independently variable.

*Fig. 2*

EP 0 208 433 A2

## RESPONSE-GAIN INDEPENDENT AMPLIFIER

Conventional operational amplifiers of the prior art generally utilize voltage feedback. The inverting and non-inverting inputs to a typical operational amplifier are high impedance nodes. In such an amplifier, the circuit gain multiplies the effect of frequency-dependent aspects of the circuit on a closed loop response. Thus, if gain is made large, the bandwidth of the amplifier circuit is reduced. In the optimum case, for a single pole response, the bandwidth will be inversely proportional to the gain; in other words, the gain-bandwidth product is a constant. In practice, however, the high frequency response is limited because of the presence of multiple poles and zeros in the amplifier response equations, and it becomes necessary to compensate the amplifier at each value of gain in order to achieve the best response. In many cases, achieving stability and freedom from oscillation severely limits the performance of the amplifier.

In brief, arrangements in accordance with the present invention comprise a pair of operational amplifier stages intercoupled in a configuration in which the inverting inputs are tied together at a common point, to which the feedback paths of the two stages are also connected. The two operational amplifier stages are standard voltage follower circuits, preferably with resistive feedback paths, connected in cascade. Terminals for coupling input signals are provided in conventional fashion, one signal ($V_{ni}$) being applied to the non-inverting input of the first stage and the other ($V_{in}$) being coupled to the inverting input common point through a series impedance.

It is the common connection of the two inverting inputs of the two stages which establishes the current feedback operation of the circuit and changes the interdependency of gain and bandwidth which has heretofore existed in operational amplifier circuits. With this circuit arrangement, using resistances for the various impedances, it becomes possible to vary the gain by varying the ratio of the series input resistance for the inverting signal input to the feedback resistance of the second stage. Bandwidth is determined by the ratio of the two feedback resistances. Thus, if the second stage feedback resistance is held constant, gain and bandwidth can be controlled independently.

In the drawing:

Fig. 1 is a functional schematic diagram representing a conventional differential input amplifier of the prior art; and

Fig. 2 is a corresponding diagram representing the preferred embodiment of the present invention.

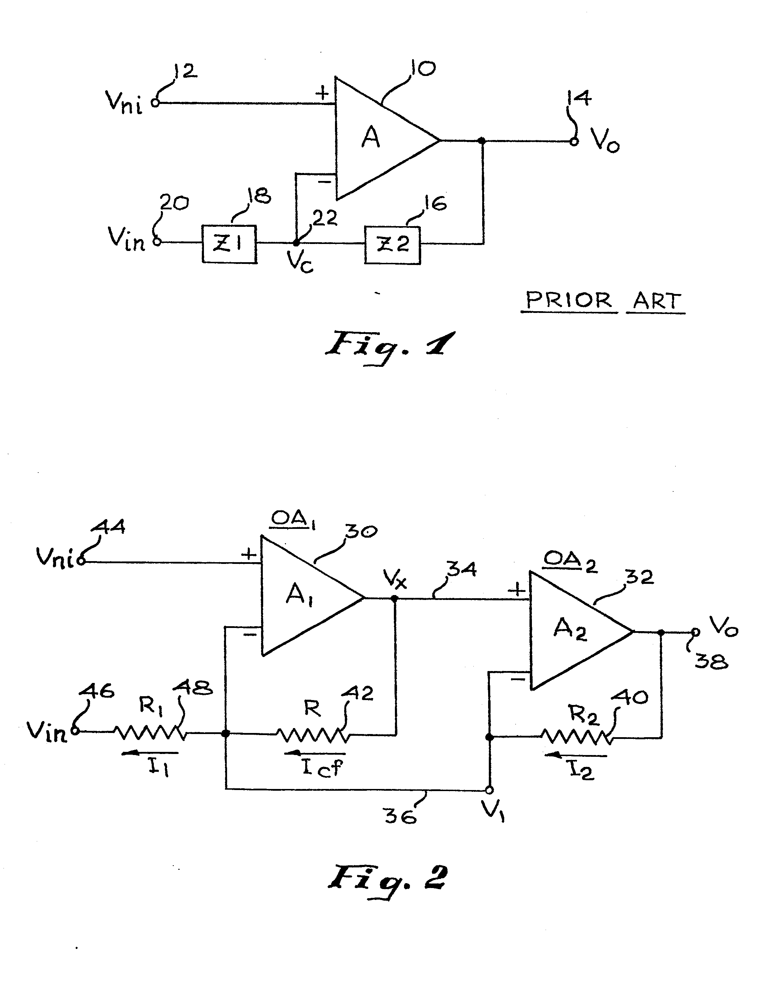

Operational amplifiers ("op amps") represent particular applications of a stabilized d-c amplifier for performing the basic mathematical operations of addition, subtraction, differentiation and integration in analog computers. Fig. 1 shows a typical d-c amplifier utilizing any stable high-gain form of the circuits described and wherein the type of operation to be performed is determined by the types of impedances (R, L or C) which are included in the circuit. Conventionally, an operational amplifier has an internal gain A which is very large and an input impedance such as to draw negligible current. With these assumptions, the output voltage (absolute value) is related to the input voltage as the ratio of the feedback impedance to the series input impedance. From long usage, conventions regarding the mathematical expressions and properties of operational amplifiers have been adopted and are well known in the art. See my own book entitled "Operational Amplifier Characteristics and Applications", Prentice-Hall 1981, the content of which is incorporated herein by reference.

In a conventional operational amplifier (Fig. 1), operation depends primarily on voltage feedback, which introduces an inherent shortcoming insofar as its usefulness in high frequency applications is concerned. In the prior art amplifier circuit of Fig. 1, an operational amplifier stage 10 is shown coupled between signal input terminal 12, designated $V_{ni}$, and output terminal 14, designated $V_o$. The input terminal 12 is coupled to the non-inverting input of the stage 10. A feedback path including a feedback impedance Z2, designated 16, is connected between the output of the amplifier stage 10 and the inverting input terminal 22. The inverting terminal of the amplifier stage is also connected, via an input impedance Z1, designated 18, to a second signal input terminal 20, designated $V_{in}$.

The circuit of Fig. 1 is shown in its most generalized form, wherein the impedances Z1 and Z2 can be combinations of resistances, capacitances, and inductances. For simplification in presenting the analysis of the operational amplifier circuits described herein, these impedances will be shown in the form of resistances. Thus, the impedance 16 will be R2 and the impedance 18 will be R1.

The two inputs to the amplifier stage 10 of Fig. 1 are high impedance nodes; thus the feedback voltage at point 22, designated $V_C$ can be expressed as follows:

$$V_C = V_O \frac{R1}{(R1 + R2)} \qquad (1)$$

This expression assumes that $V_{in} = 0$ for ease of analysis. Then, since

$$V_O = A (V_{ni} - V_C) \qquad (2)$$

it follows that

$$V_O/V_{ni} = G/(1+G/A) \qquad (3)$$

where

$$G = 1 + R2/R1 \qquad (4)$$

The amplifier transfer function A can be expressed as follows:

$$A = Z_C/P_C \qquad (5)$$

where $Z_C$ and $P_C$ are complex polynomial expressions of zeros and poles which are functions of frequency. Substituting Equation (5) into Equation (3):

$$V_O/V_{ni} = G/(1 + G P_C/Z_C) \qquad (6)$$

Thus, G not only scales the magnitude of the closed loop gain as desired, but it also multiplies the effect of $P_C$ on the closed loop response. The closed loop pole locations are now a function of G such that, if G is made large, the bandwidth will be reduced. In the optimum case, where single pole response exists, bandwidth will be inversely proportional to G. In practice, high frequency response is limited because of the presence of multiple poles and zeros, and it becomes necessary to compensate the amplifier at each value of G in order to achieve the best response. In many cases, achieving stability and freedom from oscillation severely limits the performance of an amplifier such as that shown in Fig. 1.

This type of operational amplifier follows the standard closed loop control system equation where $V_o/V_{in} = A/(1 + A B)$; in this equation, B is the feedback ratio and 1/B is the idealized closed loop gain, A is the open loop gain containing a large constant in the numerator and at least three poles in the denominator, and $V_o/V_{in}$ is the actual closed loop gain.

As the value of the numerator term becomes larger, the value of $V_o/V_{in}$ approaches 1/B as a limit. When the numerator term becomes infinite, $V_o/V_{in}$ exactly equals 1/B. The closed loop gain (1/B) is usually specified as G $= R_2/R_1 + 1$ where $R_2$ is a feedback resistor from output to inverting input and $R_1$ is a resistor from the inverting input to either signal common (non-inverting) or signal voltage (inverting). Because the denominator term contains the G term, the amplifier closed loop pole is related to the gain (G).

As G goes up, the bandwidth decreases, and as G goes down, the bandwidth increases. The two limiting values occur when G numerically equals the numerator term of A and when G = unity. The maximum bandwidth occurs for G = 1. The user is forced to accept reduced bandwidths as the gain (G) is raised as the low first dominant pole causes the gain-bandwidth product to be constant over the operating region to maintain stability.

Another form of prior art circuit (not shown) is an amplifier using current, rather than voltage feedback internally to the device. This current feedback is the difference between the two currents through $R_1$ and $R_2$. This differs from the first type where no current flows into the inverting input terminal of the device. This difference current flowing into the inverting input alters the closed loop transfer function by removing the 1/B or G term from the denominator. Thus, the closed loop gain is only a function of G = 1/B and the closed loop poles are only a function of $R_2$. The closed loop transfer function is $V_o/V_{in} = G(N_{(s)}/(N_{(s)} + R_2D_{(s)}))$. The effect of having the numerator contain only $R_2$ and not B = 1/G is that as long as $R_2$ is held constant, the bandwidth will be constant. The amplifier is still plagued with the stability problem as before, but now that correction can create a dominant pole at the highest useable frequency rather than near the lowest useable frequency.

In both the first and second types of amplifier, the closed loop gain is G = $R_2/R_1$ + 1 for the non-inverting case and $-R_2/R_1$ for the inverting case. The major operating difference between the two types of amplifiers is that $R_2$, together with $R_1$, usually sets the closed loop gain in the first type while in the second type, $R_2$ is held constant and $R_1$ sets the closed loop gain.

In the embodiment of the invention represented in Fig. 2, a pair of operational amplifiers 30, designated $OA_1$ and having a gain $A_1$, and 32, designated $OA_2$ with an internal gain of $A_2$, are intercoupled as shown. The output of amplifier stage 30 on line 34, designated $V_x$, is coupled to the non-inverting input of amplifier stage 32. The two inverting inputs of the amplifier stages 30, 32 are connected together at a common baseline 36, designated $V_1$. The output of the amplifier stage 32 is the circuit output 38, designated $V_o$. A feedback path including resistor 40, designated R2, is coupled between the points 38 and 36. A feedback resistor 42, designated R, is coupled between the points 34 and 36. The $V_{ni}$ signal input at terminal 44 is coupled to the non-inverting input of the amplifier stage 30. The inverting signal input $V_{in}$ at terminal 46 is coupled through a resistor 48,

designated Rl, to the line 36. Currents $I_1$ and $I_2$ flow in the directions of the arrows through Rl and R2, respectively. A feedback current $I_{cf}$ flows through R.

Referring now to Fig. 2, amplifier $OA_1$ has an open loop gain response defined by $A_1 = N_1/D_1$ and amplifier $OA_2$ has an open loop gain response of $A_2 = N_2/D_2$. (In this convention, N is a numerator term representing zeros and D is a denominator term representing poles.) Amplifier $OA_1$ is connected as a voltage follower with a feedback resistor between output and inverting input; this resistor does not affect the amplifier's unity closed loop gain. Resistor R is both in series with $OA_1$'s output and across the two inputs of amplifier $OA_2$. The net effect of this connection is to yield an overall transfer function of the current feedback type described above with a few minor differences. The exact and approximate gain equations of the Fig. 2 circuit are derived as follows:

<div align="center">EXACT GAIN EQUATIONS FOR</div>

<div align="center">"RESPONSE-GAIN INDEPENDENCE" OPERATIONAL AMPLIFIER</div>

The exact gain equations are set forth below. The current I and voltage V terms correspond to Fig. 2. The derivations for these equations may be found in the attached Appendix A (non-inverting) and Appendix B (inverting).

EQUATION (7)—NON-INVERTING GAIN:

$$\frac{V_o}{V_{in}} = \frac{A_1A_2R^2R_1R_2(R_1+R_2)}{A_1A_2R^2R_1^2R_2 + A_2(R^3R_1^2 + R^3R_1R_2 + R^2R_1^2R_2 + R^3R_1^2 + R^3R_1R_2) + A_1R^2R_1R_2^2 + R^2R_1R_2^2 + R^3R_1R_2 + R^3R_2^2}$$

When $A_1$ and $A_2$ are very large, the first term in the denominator dominates and the equation becomes

$$\frac{V_o}{V_{ni}} = \frac{R_1 + R_2}{R_1} = G_{ni}$$

INVERTING GAIN EQUATION:

$$\frac{V_o}{V_{in}} = -\left[\frac{A_1 A_2 R^2 R_1 R_2^2 + A_1 RR_1 R_2^3 - A_1 RR_1 R_2^3 - RR_1 R_2^3 - R^2 R_1 R_2^2 - R^2 R_2^3}{A_1 A_2 R^2 R_1^2 R_2 + A_1 RR_1^2 R_2^2}\right] \quad (8)$$

When $A_1$ and $A_2$ are very large, the first terms in the numerator and denominator dominate and the equation becomes

$$\frac{V_o}{V_{in}} = -\frac{R_2}{R_1} = G_{in}$$

## OPERATIONAL CHARACTERISTICS

The amplifier's transfer functions can be derived and re-arranged to illustrate the constituent parts of the transfer function. Appendix C derives the transfer function for the non-inverting case and Appendix D derives the transfer function for the inverting case. The results are repeated below:

NON-INVERTING TRANSFER FUNCTION

$$\frac{V_o}{V_{ni}} = (\frac{R2}{R1} + 1)(\frac{R}{R2})\left[\frac{(\frac{N_s}{D_s})}{1 + (\frac{N_s}{D_s})(\frac{R}{R2})}\right] \quad \text{where } G_{ni} = (\frac{R2}{R1} + 1)$$

INVERTING TRANSFER FUNCTION

$$\frac{V_o}{V_{in}} = (-\frac{R_2}{R_1})(\frac{R}{R_2})\left[\frac{(\frac{N_s}{D_s})}{1 + (\frac{N_s}{D_s})(\frac{R}{R_2})}\right] \quad \text{where } G_{in} = (-\frac{R_2}{R_1})$$

These equations, when analyzed, reveal that:

1. The actual gain is independent of the bandwidth as the last term is a standard control function equation with $R/R_2$ being the psuedo B function. This means that the $-3dB$ point for the bracketed control function is only dependent upon the ratio of $R_2/R$. As this ratio becomes larger, the bandwidth decreases as in a standard operational amplifier. As the ratio becomes close to unity, the bandwidth approaches the gain-bandwidth frequency limit $(f_T)$ for the second stage amplifier. Thus, the bandwidth can be controlled by setting the resistor ratios.

2. Since also the $R/R_2$ function appears as a multiplier of this bracketed control function, the approximate gain of the control function and the multiplier $R/R_2$ are reciprocals and, if the $A_2$ gain is large, they cancel. This leaves only the G multiplier term to establish the circuit closed loop gain. Regardless of the value of the resistor ratios, this is true.

3. Because of the independence of the $-3dB$ rolloff frequency, established by the resistor ratio $(R/R_2)$ and the closed loop gain (G), the circuit gain is theoretically and practically independent of the circuit bandwidth.

4. The circuit gain is established by altering the value of $R_1$. This creates some new problems as many of the current circuits in use today alter the circuit gain by changing $R_2$. As this circuit becomes more widely used, new circuits will have to be developed that make use of the input resistor changing value with, say, frequency. Active filters are a prime example of this situation.

5. The open loop gain of the second stage is a function of the value of R. This means that as R becomes smaller, the parameters such as voltage precision degrade. As R becomes larger, the difference feedback current ($I_{cf}$) creates a compliance voltage across R which, if it becomes too large, could saturate the $OA_1$ amplifier output. Thus the value of R must be as large as possible for precision voltage amplification but not large enough to saturate the first amplifier.

6. When R has a value equal to $R_1$ in parallel with $R_2$, the device reverts to having the parameters of a standard operational amplifier (Fig. 1).

7. The second stage must be compensated for stability in the same manner as any 3 pole uncompensated operational amplifier. Two methods are available:

    a. A dominant pole capacitor can be placed across the differential amplifier stage of $A_2$ or at any other high impedance point in the signal path within $A_2$. This assures that the loop phase is +90° over the whole frequency response until the open loop gain ($A_2$) is unity or below. This is the most desirable method for second stage stabilization.

    b. The closed loop gain of the control relation, $1/B = R_2/R$, must be raised by increasing $R_2$ in relation to R to a value such that the loop gain, $A_2(R/R_2)$, has become unity or below when the loop phase reaches 0° (amplifier phase = 180°). This ratio should be raised sufficiently above the gain at 180° to yield a gain margin of +20 dB and a corresponding phase margin of about 50°. The method just described produces an amplifier with decreased bandwidth, thus having poorer settling times and precision voltage control.

APPENDIX A

Referring to Figure 2 where $V_{in} = 0$,

(1)  $V_x = (V_{ni} - V_1)A_1$

(2)  $I_1 = I_{cf} + I_2$

(3)  $\dfrac{V_1}{R_1} = \dfrac{V_x - V_1}{R} + \dfrac{V_0 - V_1}{R_2}$  Insert (1) into (3),

(4)  $\dfrac{V_1}{R_1} = \dfrac{A_1 V_{ni} - A_1 V_1 - V_1}{R} + \dfrac{V_0 - V_1}{R_2}$  after rearranging,

(5)  $V_1 = V_{ni}\left[\dfrac{A_1 R_1 R_2}{(1 + A_1)R_1 R_2 + R(R_1 + R_2)}\right] + V_0\left[\dfrac{R R_1}{(1 + A_1)R_1 R_2 + R(R_1 + R_2)}\right]$

(1a)  $V_0 = (V_x - V_1)A_2$,  $V_x - V_1 = \dfrac{V_0}{A_2}$  insert (1a) into (3)

(6)  $\dfrac{V_1}{R_1} = \dfrac{V_0/A_2}{R} + \dfrac{V_0 - V_1}{R_2}$  which, after rearranging, becomes

(7)  $V_1 = V_0\left[\dfrac{A_2 R R_1 + R_1 R_2}{A_2 R(R_1 + R_2)}\right]$  insert (7) into (5),

(8)  $\dfrac{V_0}{V_{ni}} = \dfrac{A_1 A_2 R^2 R_1 R_2(R_1 + R_2)}{A_1 A_2 R^2 R_1^2 R_2 + A_2(R^3 R_1^2 + R^3 R_1 R_2 + R^2 R_1^2 R_2 + R^3 R_1^2 + R^3 R_1 R_2) + A_1 R^2 R R_2^2 + R^2 R_1 R_2^2 + R^3 R_1 R_2 + R^3 R_2^2}$

when $A_1$ and $A_2$ become very large, the first term in the denominator dominates and the equation reduces to

(9)  $\dfrac{V_0}{V_{ni}} = \dfrac{(R_1 + R_2)}{R_1} = G$

13

## APPENDIX B

Referring to Figure 2 where $V_{ni} = 0$,

0208433

(1)  $V_x = (0 - V_1)A_1$,  $V_1 = -\dfrac{V_x}{A_1}$

(2)  $I_1 = I_{cf} + I_2$

(3)  $\dfrac{V_1 - V_{in}}{R_1} = \dfrac{V_x - V_1}{R} + \dfrac{V_0 - V_1}{R_2}$  inserting (1) into (3)

(4)  $\dfrac{-V_x/A_1}{R_1} - \dfrac{V_{in}}{R_1} = \dfrac{V_x}{R} - \dfrac{-V_x/A_1}{R} + \dfrac{V_0}{R_2} - \dfrac{-V_x/A_1}{R_2}$

which, after rearranging, becomes

(5)  $V_x = -V_{in}\left[\dfrac{A_1RR_2}{(A_1 + 1)R_1R_2 + R(R_1 + R_2)}\right] - V_0\left[\dfrac{A_1RR_1}{(A_1 + 1)R_1R_2 + R(R_1 + R_2)}\right]$

When $A_1$ is very large, $V_1 = V_{ni} = 0$, then (3) becomes

(5)  $-\left(\dfrac{V_{in}}{R_1}\right) = \dfrac{V_x}{R} + \dfrac{V_0}{R_2}$

(6)  $(V_x - 0)A_2 = V_0$,   $V_0 = A_2V_x$   insert (6) into (5),

(7)  $-\left(\dfrac{V_{in}}{R_1}\right) = \dfrac{V_x}{R} + \dfrac{A_2V_x}{R_2}$  which, when rearranged, becomes

(8)  $V_x = -V_{in}\left[\dfrac{RR_2}{A_2RR_1 + R_1R_2}\right]$  inserting (8) into (5)

(9)  $\dfrac{V_0}{V_{in}} = -\left[\dfrac{A_1A_2R^2R_1R_2^2 + A_1RR_1R_2^3 - A_1RR_1R_2^3 - RR_1R_2^3 - R^2R_1R_2^2 - R^2R_2^3}{A_1A_2R^2R_1^2R_2 + A_1RR_1^2R_2^2}\right]$

when $A_1$ and $A_2$ are very large, the first term in the numerator and denominator dominate, then

(10)  $\dfrac{V_0}{V_{in}} = -\dfrac{R_2}{R_1} = G$

## APPENDIX C

### NON-INVERTING TRANSFER FUNCTION

0208433

Referring to Figure 2 with $V_{in} = 0$ (grounded) and $V_1 = V_{ni}$ because of the large $A_1$.

(1) $I_{cf} = I_1 - I_2 \qquad I_1 = \dfrac{V_1 - 0}{R_1}, \quad I_2 = \dfrac{V_0 - V_1}{R_2}$

(2) $I_{cf} = \dfrac{V_1}{R_1} \quad \dfrac{V_0 - V_1}{R_2}$ \qquad (3) $V_x - V_1 = I_{cf}R = \dfrac{V_0}{A_2}, \quad I_{cf} = \dfrac{V_0}{A_2 R}$

(4) $\dfrac{V_0}{A_2 R} = \dfrac{V_1}{R_1} - \dfrac{V_0 - V_1}{R_2}, \qquad V_0 \dfrac{R_2 + A_2 R}{A_2 R R_2} = V_1 \dfrac{R_1 + R_2}{R_1 R_2}$ but $V_1 = V_{ni}$

After rearranging

(5) $\dfrac{V_0}{V_{ni}} = \dfrac{A_2 R(R_1 + R_2)}{R_1 R_2 + A_2 R R_1} \qquad G_{ni} = \dfrac{R_1 + R_2}{R_1} = (\dfrac{R_2}{R_1} + 1)$

now placing in the form: $\quad T_{(s)} = \dfrac{A}{1 + A\beta}$

(6) $\dfrac{V_0}{V_{ni}} = (G_{ni})(\dfrac{R}{R_2})\left[\dfrac{A_2}{1 + A_2(\dfrac{R}{R_2})}\right]$ \quad where $A = A_2$ and $\beta = \dfrac{R}{R_2}$

If $A_2 = N_{(s)}/D_{(s)}$ where $N_{(s)}$ are numerator zeros and $D_{(s)}$ are denominator poles, then

(7) $\dfrac{V_0}{V_{ni}} = (G_{ni})(\dfrac{R}{R_2})\left[\dfrac{(\dfrac{N_s}{D_s})}{1 + (\dfrac{N_s}{D_s})(\dfrac{R}{R_2})}\right]$

# APPENDIX D

## INVERTING TRANSFER FUNCTION

0208433

Referring to Figure 2, $V_{ni} = 0$ (grounded); $V_1 = 0$ also because of the large $A_1$ gain.

(1) $I_{cf} = I_1 - I_2$   $I_1 = \dfrac{0 - V_{in}}{R_1}$ ,   $I_2 = \dfrac{V_o - 0}{R_2}$

(2) $I_{cf} = \dfrac{-V_{in}}{R_1}$   $\dfrac{V_o}{R_2}$      $V_x - 0 = I_{cf}R = \dfrac{V_o}{A_2}$ ,   $I_{cf} = \dfrac{V_o}{A_2 R}$

(3) $\dfrac{V_o}{A_2 R} = -\dfrac{V_{in}}{R_1} - \dfrac{V_o}{R_2}$   after rearranging

(4) $\dfrac{V_o}{V_{in}} = -\dfrac{A_2 R R_2}{R_1 R_2 + A_2 R R_1}$      $G_{in} = -\dfrac{R_2}{R_1}$

now placing in the form:   $T_{(s)} = \dfrac{A}{1 + A\beta}$

(5) $\dfrac{V_o}{V_{in}} = (-\dfrac{R_2}{R_1})(\dfrac{R}{R_2})\left[\dfrac{A_2}{1 + A_2(\dfrac{R}{R_2})}\right]$   where $A = A_2$ and $\beta = \dfrac{R}{R_2}$

NOTE:   $G_{in} = (-R_2/R_1)$

If $A_2 = N_{(s)}/D_{(s)}$   where $N_{(s)}$ are numerator zeros and $D_{(s)}$ are denominator poles, then

(7) $\dfrac{V_o}{V_{in}} = (G_{in})(\dfrac{R}{R_2})\left[\dfrac{(\dfrac{N_s}{D_s})}{1 + (\dfrac{N_s}{D_s})(\dfrac{R}{R_2})}\right]$

NOTE:   $G_{in} = (-R_2/R_1)$

CLAIMS

1. The method of operating an electronic amplifier circuit to control circuit gain and bandwidth independently comprising the steps of interconnecting first and second operational amplifier stages in cascade, each of said stages having a non-inverting input terminal, an inverting input terminal, an output terminal and a feedback resistor connected between the inverting input terminal and the output terminal; connecting the non-inverting input terminal of the second stage to the output terminal of the first stage; characterized by connecting the inverting terminals and the feedback resistors of the two stages directly together at a common node to develop current feedback operation; connecting a first circuit input terminal to the non-inverting input terminal of the first stage and a second circuit input terminal through a series input resistor to the common node; and controlling the the gain of the circuit by selectively setting the ratio of the series input resistance to the feedback resistance of the second stage.

2. The method of claim 1 further characterized by the step of determining the bandwidth of the circuit by selectively setting the ratio of the feedback resistance of the first stage to the feedback resistance of the second stage.

3. The method of claim 1 or claim 2 further characterized by determining circuit gain and bandwidth independently of each other by the steps of setting the feedback resistance of the second stage at a fixed value and independently selecting the value of the series input resistance to control circuit gain and the value of the feedback resistance of the first stage to control circuit bandwidth.

4. An electronic amplifier circuit for use with the method of claim 1 including first and second operational amplifier stages ($OA_1$, $OA_2$), each stage having non-inverting and inverting input terminals (44, 36 and 34, 36), an output terminal ($V_x$ and 38) and a feedback impedance path (42 and 40) connected between the output terminal and the inverting input terminal (36); means for connecting the stages in cascade with the non-inverting input terminal (34) of the second stage connected to the output terminal ($V_x$) of the first stage; characterized by the inverting terminal of each stage and the feedback impedance of each stage being connected directly together at a common point ($V_1$) to establish current feedback operation of the circuit.

5. The circuit of claim 4 further characterized by input signal applying means in the form of a first input terminal ($V_{ni}$) connected directly to the non-inverting input terminal of the first stage ($OA_1$) and a second input terminal ($V_{in}$) coupled in series with a circuit input impedance (48) to the common point ($V_1$).

6. The circuit of claim 5 further characterized by the first input (44) terminal being the non-inverting input terminal ($V_{ni}$) for the overall circuit, the second input terminal (46) being the inverting input terminal ($V_{in}$) for the overall circuit, and the output terminal (38) of the second stage being the output terminal of the overall circuit ($V_o$).

7. The circuit of claim 6 wherein the gain of each of the operational amplifier stages is very large, further characterized by the ratio of the signal amplitude at the circuit output terminal ($V_o$) to the signal amplitude at the non-inverting input terminal ($V_{ni}$) being approximately equal to the ratio of the sum of the input impedance (48) and the feedback impedance (40) of the second operational stage divided by the input impedance (48).

8. The circuit of claim 6 wherein the individual gains of the operational amplifier stages are very large, further characterized by the ratio of the signal amplitude at the circuit output terminal ($V_o$) to the signal amplitude at the inverting input terminal ($V_{in}$) being approximately equal to the ratio of the feedback impedance of the second stage (40) to the input impedance (48) multiplied by minus 1.

9. The circuit of claim 6 wherein the feedback impedances (40, 42) of the operational amplifier stages and the circuit input impedance (48) are resistances, further characterized by the gain of the amplifier circuit being variable in accordance with variations in the ratio of the input resistance (48) to the feedback resistance of the second stage (40).

10. The circuit of claim 9 wherein the ratio of the two feedback resistances (40, 42) is variable, further characterized by the bandwidth of the circuit being determined by the ratio of the two feedback resistances (40, 42).

11. The circuit of claim 10 wherein the feedback resistance (40) of the second stage is fixed, further characterized by the circuit gain and bandwidth being controllable independently by adjusting the series input resistance (48) and the feedback resistance of the first stage (42) independently.

PRIOR ART

Fig. 1

Fig. 2